# EUROPÄISCHE PATENTSCHRIFT

(11) **EP 2 612 109 B1**
(45) Veröffentlichungstag und Bekanntmachung des Hinweises auf die Patenterteilung: **04.06.2014**
(21) Anmeldenummer: 10757721.5
(22) Anmeldetag: 03.09.2010
(51) Int. Cl.: G01B 11/27, G01B 21/24

(54) **VORRICHTUNG UND VERFAHREN ZUR VERRINGERUNG EINES KEILFEHLERS**
DEVICE AND METHOD FOR REDUCING A WEDGE ERROR
DISPOSITIF ET PROCÉDÉ POUR RÉDUIRE UNE ERREUR DE CLAVETTE

(43) Veröffentlichungstag der Anmeldung: 10.07.2013
(73) Patentinhaber: Ev Group E. Thallner GmbH, 4782 St. Florian am Inn (AT)
(72) Erfinder: KAST, Michael, A-4600 Wels (AT); GRÜNSEIS, Christian, A-4941 Mehrnbach (AT); MALZER, Alois, A-4792 Münzkirchen (AT)
(74) Vertreter: Schweiger, Johannes
(86) Internationale Anmeldenummer: PCT/EP2010/005423
(87) Internationale Veröffentlichungsnummer: WO 2012/028166

(56) Entgegenhaltungen:
- DE-A1- 3 623 891
- DE-A1- 10 139 586
- JP-A- 55 016 457
- JP-A- 58 103 136
- US-A1- 2005 064 054

## Beschreibung

Die vorliegende Erfindung betrifft eine Vorrichtung zur gegenüberliegenden Ausrichtung einer ersten Oberfläche eines ersten Substrats mit einer zweiten Oberfläche eines zweiten Substrats mit Abstand zwischen der ersten und der zweiten Oberfläche gemäß Patentanspruch 1 sowie ein korrespondierendes Verfahren gemäß Patentanspruch 9.

Die DE 101 39 586 A1 zeigt ein plattenförmiges Justierelement. Die JP 58103136 A betrifft einen Spalteinsteller zur Steuerung des Spalts in Bezug auf die gesamte Oberfläche eines Wafers. Die JP 55016457 A betrifft eine Einrichtung, um den Spalt zwischen einer Maske und einem Wafer auf einem spezifischen Wert zu halten. Die US 2005/0064054 A1 zeigt eine Mustererzeugungsvorrichtung mit einem Mechanismus zur Ausrichtung des Stempels und des Substrats senkrecht zu der Pressrichtung.

In der Halbleiterindustrie gibt es eine Vielzahl von Vorrichtungen und Verfahren, bei welchen eine Kalibrierung zweier Oberflächen zueinander von großer Bedeutung ist. Bei den Oberflächen handelt es sich meist um strukturierte Oberflächen, deren Strukturen zueinander ausgerichtet werden müssen. Bei allen Verfahren, die solche Kalibrierungen vornehmen, wäre es wünschenswert, dass Fehler bei der Ausrichtung, insbesondere Keilfehler, also Abweichungen in der Winkellage der beiden gegenüberliegend auszurichtenden Oberflächen minimiert beziehungsweise weitgehend ausgeschlossen werden. Idealerweise sollen die Oberflächen der Substrate in einer Endposition, also beispielsweise beim Prägen einer Mikrolinse oder beim Erzeugen einer Maske im Lithografieverfahren genau parallel zueinander ausgerichtet sein. Am Beispiel der Mikrosystemtechnik, insbesondere der Herstellung von Mikrolinsen, die als optische Linsen und auf Grund des Miniaturisierungsdrucks in der Halbleiterindustrie gleichzeitig kleiner und immer genauer werden müssen, wirken sich die obengenannten Fehler besonders drastisch aus.

Mithin ist es besonders wichtig, dass die optische Achse der Mikrolinse keine Ausrichtungsfehler aufweist, die insbesondere durch Keilfehler verursacht werden. Mikrolinsen werden häufig übereinander gestapelt, so dass sich die Keilfehler entsprechend potenzieren und die Bildqualität entsprechend leidet.

Weiterhin gehen die Bemühungen dahin, den Ausschuss bei der Massenproduktion von Mikrolinsen zu minimieren.

Der obengenannte Keilfehler entsteht durch eine Fehlstellung der Prägesubstrate zueinander beziehungsweise der die Prägesubstrate aufnehmenden Aufnahmeeinrichtungen zueinander in der für die Herstellung der zu prägenden Bauteile, insbesondere Mikrolinsen, entscheidenden Endposition, in der das Prägematerial ausgehärtet wird.

Eine Reduzierung des Keilfehlers erfolgt bisher durch möglichst genaue parallele Ausrichtung der Aufnahmeeinrichtungen vor einer Annäherung der Aufnahmeeinrichtungen, indem der Abstand zwischen den Oberflächen der Substrate vor dem eigentlichen Prägevorgang, bei dem die Substrate in Translationsrichtung aufeinander zu bewegt werden, parallel ausgerichtet werden.

Aufgabe der vorliegenden Erfindung ist es, eine Vorrichtung und ein Verfahren anzugeben, mit welchem Ausrichtungsfehler bei der Ausrichtung zweier beabstandeter Substrate minimiert werden können, wodurch die Qualität der zu erzeugenden Produkte steigt und die Herstellungskosten drastisch reduziert werden.

Diese Aufgabe wird mit den Merkmalen der Ansprüche 1 und 9 gelöst. Vorteilhafte Weiterbildungen der Erfindung sind in den abhängigen Ansprüchen angegeben.

Der Erfindung liegt der Gedanke zugrunde, Ausrichtungsfehler zwischen zwei Substraten nicht schon vor der Annäherung der Substrate in die Endposition, sondern während der Annäherung und bis zum Erreichen der Endposition eine Verringerung von Ausrichtungsfehlern, insbesondere eines Keilfehlers, vorzunehmen. Auf die Einführung einer Messeinrichtung zwischen die auszurichtenden Substrate kann demnach erfindungsgemäß verzichtet werden. Die Abstände beziehungsweise die Winkellage des ersten zum zweiten Substrat beziehungsweise der ersten Aufnahmeeinrichtung und der zweiten Aufnahmeeinrichtung während der Annäherung der Substrate werden erfindungsgemäß von außerhalb des zwischen der ersten und zweiten Oberfläche gebildeten Arbeitsraumes gemessen, so dass eine in-situ-Messung während der Annäherung der Substrate ermöglicht wird, und zwar bis zur Fertigstellung des mit der Vorrichtung herzustellenden Produktes, insbesondere eines Mikrolinsenfeldes oder einer Maske.

Soweit ein durch das erste und zweite Substrat zu prägendes Prägematerial in den Zwischenraum eingebracht wird, erfolgt die Ausrichtung erfindungsgemäß nach Einbringung des Prägematerials in den Zwischenraum beziehungsweise Einbringung des Prägematerials auf das als Trägersubstrat ausgebildete erste oder zweite Substrat. Besonders vorteilhaft ist es, wenn die Verringerung des Keilfehlers kurz vor oder bei Erreichen der Endposition erfolgt, da somit Fehler durch eine weitere Bewegung des ersten und/oder zweiten Substrats praktisch ausgeschlossen werden können.

Gemäß einer vorteilhaften Ausführungsform der Erfindung ist vorgesehen, dass die Mittel zur Verringerung des Keilfehlers kontinuierlich, insbesondere ununterbrochen, während der Annäherung, insbesondere bis zum Erreichen der Endposition, einsetzbar sind. Besonders vorteilhaft ist die Ausführung der Erfindung in Verbindung mit Nanoimprintverfahren, soweit auf der ersten Oberfläche und/oder der zweiten Oberfläche Prägestrukturen zum Prägen eines Prägematerials zwischen der ersten und der zweiten Oberfläche vorgesehen sind.

Im Rahmen der Erfindung ist vorgesehen, dass die Mittel zur Verringerung des Keilfehlers spektroskopisch arbeitende Messmittel zur Messung der Winkellage zwischen dem ersten Substrat und dem zweiten Substrat während der Annäherung der ersten Oberfläche zur zweiten Oberfläche umfassen. Durch Messung der Winkellage der ersten und zweiten Oberflächen zueinander während der Annäherung der ersten Oberfläche an die zweite Oberfläche oder umgekehrt bis zu der Endposition kann auf das erste Substrat und/oder das zweite Substrat beziehungsweise die erste Aufnahmeeinrichtung und/oder die zweite Aufnahmeeinrichtung durch die Mittel zur Verringerung des Keilfehlers entsprechend eingewirkt werden, um die erste und zweite Oberfläche parallel auszurichten, so dass im Idealfall kein Keilfehler mehr vorliegt, insbesondere bei Erreichen der Endposition.

Dabei ist weiter vorgesehen, dass die Messmittel mehrere, insbesondere mindestens drei, insbesondere in der ersten und/oder zweiten Aufnahmeeinrichtung jeweils unterhalb der ersten und/oder zweiten Aufnahmefläche verbaute, Sensoren zur Messung der Abstände der ersten Oberfläche und der zweiten Oberfläche zu dem jeweiligen Sensor in Translationsrichtung, sowie insbesondere der Abstände einer der ersten Oberfläche abgewandten ersten Auflagefläche des ersten Substrats und einer der zweiten Oberfläche abgewandten zweiten Auflagefläche des zweiten Substrats, aufweisen. Durch Integration der Sensoren ist eine besonders platzsparende und sichere Erfassung der Winkellage der Aufnahmeflächen beziehungsweise der Oberflächen in-situ möglich.

Mit Vorteil ist in einer Ausführungsform der Erfindung weiterhin vorgesehen, dass die Mittel zur Verringerung des Keilfehlers Antriebsmittel zur Änderung der Winkellage des ersten Substrats zum zweiten Substrat, insbesondere der ersten Oberfläche zur zweiten Oberfläche, umfassen, wobei die Antriebsmittel an der ersten und/oder zweiten Aufnahmeeinrichtung angeordnet sind. Als Antriebsmittel kommen insbesondere Motoren für jede Aufnahmeeinrichtung in Frage, die für mindestens eine der Aufnahmeeinrichtungen mindestens zwei, insbesondere drei Rotationsfreiheitsgrade zur Verfügung stellen, deren Rotationsachsen normal zueinander stehen und welche die Aufnahmeeinrichtung beliebig zu der Translationsrichtung kippen können.

Gemäß einer weiteren vorteilhaften Ausführungsform der Erfindung ist vorgesehen, dass die Mittel zur Verringerung des Keilfehlers eine aktive Steuerungseinrichtung zur Steuerung der Verringerung des Keilfehlers, insbesondere zur Erfassung von Messwerten der Messmittel und zur korrespondierenden Ansteuerung der Antriebsmittel, aufweisen. Die aktive Steuerungseinrichtung sorgt auf Basis der Messwerte der Messmittel, also der Abstände zwischen den Sensoren und der einzelnen, erfindungsgemäß relevanten Flächen (Oberflächen/Auflageflächen) für eine selbsttätige Nachregelung der entsprechenden Antriebsmittel, damit zu jedem Zeitpunkt eine parallele Ausrichtung der ersten Oberfläche zur zweiten Oberfläche gewährleistet ist.

Das erfindungsgemäße Verfahren ist im unabhängigen Patentanspruch 9 definiert.

Ein Verfahren, auf das jedoch kein Patentanspruch gerichtet ist, kann die folgenden Schritte aufweisen, insbesondere in der nachfolgend aufgeführten Reihenfolge:
- Fixieren des ersten Substrats mit seiner Aufnahmefläche auf der ersten Aufnahmeeinrichtung und Fixieren des zweiten Substrats mit seiner Aufnahmefläche auf der zweiten Aufnahmeeinrichtung,
- Ausrichtung des ersten Substrats zum zweiten Substrat quer zur Translationsrichtung,
- Aufbringen einer Prägestruktur auf die erste Oberfläche des ersten Substrats und Aufbringen eines Trägematerials auf die zweite Oberfläche des zweiten Substrats,
- Annäherung des ersten Substrats an das zweite Substrat durch translatorische Bewegung der der ersten Aufnahmeeinrichtung in Richtung der zweiten Aufnahmeeinrichtung und
- Messung der Abstände zwischen dem ersten und zweiten Substrat und jedem Sensor der zweiten Aufnahmeeinrichtung während der Annäherung des ersten Substrats an das zweite Substrat und sobald das erste Substrat im Erfassungsbereich der Sensoren ist;
- Auswertung der Messwerte und Berechnung der Winkellage des ersten Substrats zum zweiten Substrats durch die Steuereinrichtung und Steuerung von Antriebsmitteln zur Verringerung des Keilfehlers zwischen dem ersten Substrat und dem zweiten Substrat, indem die Antriebsmittel entsprechend angesteuert werden und das erste Substrat beziehungsweise die erste Aufnahmeeinrichtung gegenüber dem zweiten Substrat beziehungsweise der zweiten Aufnahmeeinrichtung entsprechend rotiert werden.

Weitere Vorteile, Merkmale und Einzelheiten der in den Patentansprüchen 1 und 9 definierten Erfindung ergeben sich aus nachfolgender Figurenbeschreibung einer bevorzugten Ausführungsform der Erfindung.

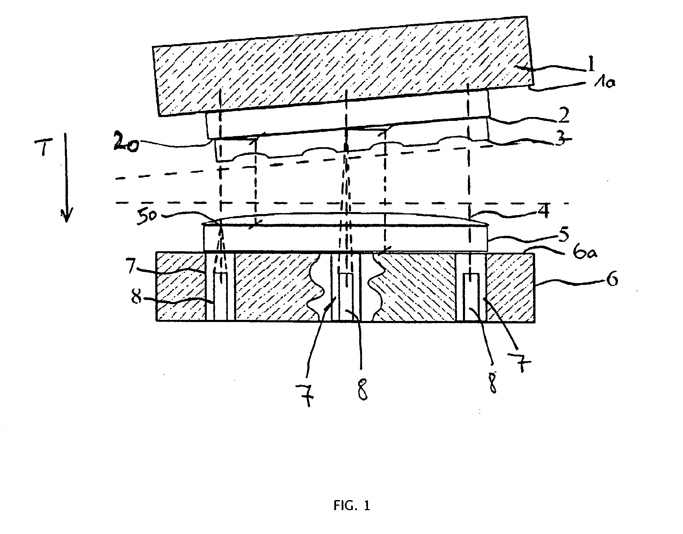

Figur 1 zeigt eine Querschnittsansicht der erfindungsgemäßen Vorrichtung zur Verringerung eines Keilfehlers.

In Figur 1 ist eine erste Aufnahmeeinrichtung einer Vorrichtung zur gegenüberliegenden Ausrichtung einer ersten Oberfläche 2o eines ersten Substrats 2 mit einer zweiten Oberfläche 5o eines zweiten Substrats 5 mit Abstand zwischen der ersten Oberfläche 2o und der zweiten Oberfläche 5o dargestellt, wobei das zweite Substrat 5 auf einer zweiten Aufnahmefläche 6o einer zweiten Aufnahmeeinrichtung 6 fixiert ist. Die Fixierung des ersten Substrats 2 auf der ersten Aufnahmeeinrichtung 1 sowie die Fixierung des zweiten Substrats 5 auf der zweiten Aufnahmeeinrichtung 6 erfolgt beispielsweise durch Anlegen eines Unterdrucks an einer Aufnahmefläche 1a der ersten Aufnahmeeinrichtung 1 beziehungsweise Aufnahmefläche 6a der zweiten Aufnahmeeinrichtung 6.

An der Oberfläche 2o ist eine Prägestruktur 3 angebracht, die zum Prägen eines auf der Oberfläche 5o aufgebrachten Prägematerials 4 dient. Das Prägematerial 4 ist beispielsweise ein Polymer, das beim Prägen die Kontur der Prägestruktur 3 annimmt, und zwar in einer Endposition, in der die Prägestruktur 3 in das Prägematerial 4 eintaucht, um entsprechend der Kontur der Prägestruktur 3 eine Vielzahl von exakt dimensionierten Produkten, hier Mikrolinsen herzustellen. Durch die gezeigte Anordnung wird ein Mikrolinsenfeld aus dem Prägematerial geprägt und ausgehärtet, so dass aus dem Mikrolinsenfeld später eine bzw. viele Mikrolinsen hergestellt werden können.

Zum Prägen wird das erste Substrat 2 zunächst gegenüberliegend zu dem zweiten Substrat 5 fluchtend und parallel ausgerichtet, wobei ein - in der Figur 1 übertrieben dargestellter - Keilfehler, dargestellt durch die Winkellage des ersten Substrats 2 und des zweiten Substrats 5 repräsentierende Strichlinien, vorherrscht. Der Keilfehler kann aus einer Schieflage der ersten Aufnahmeeinrichtung 1 oder der zweiten Aufnahmeeinrichtung 6 relativ zueinander und/oder gegenüber einer Translationsrichtung T sowie uneinheitlicher Dicke des ersten Substrats 2 und/oder des zweiten Substrats 5 beziehungsweise einer Summe der vorgenannten Ursachen resultieren.

Die erste Aufnahmeeinrichtung 1 ist durch einen nicht dargestellten Translationsantrieb in Translationsrichtung T auf die zweite Aufnahmeeinrichtung 6 hin bewegbar, auch als Annäherungsmittel zur Annäherung der ersten Oberfläche 2o zur zweiten Oberfläche 5o bezeichnet. Der Translationsantrieb kann beispielsweise ein nicht dargestellter Roboterarm sein, der die erste Aufnahmeeinrichtung 1 greift. Die zweite Aufnahmeeinrichtung 6 kann als Chuck in der Vorrichtung fixiert ausgebildet sein. Eine Umkehrung der Bewegung beider Aufnahmeeinrichtungen ist erfindungsgemäß denkbar.

Während der Annäherung des ersten Substrats 2 beziehungsweise der Prägestruktur 3 an das zweite Substrat 5 beziehungsweise das Prägematerial 4 sind als Mittel zur Verringerung des Keilfehlers unter anderem mehrere Sensoren 8 in Sensorkammern 7 der zweiten Aufnahmeeinrichtung 6 verteilt vorgesehen. Die Sensoren 8 sind als spektroskopische Sensoren derart ausgebildet, dass jeder Sensor 8 einen Lichtstrahl aussendet, über dessen Reflektionen und der Spektroskopie des reflektierten Lichts die Abstände der im Lichtstrahl angeordneten ersten Oberfläche 2o sowie zweiten Oberfläche 5o zu dem Sensor 8 messbar sind. Durch Differenzbildung der Abstände kann - im Erfassungsbereich des jeweiligen Sensors 8 - zu jedem Zeitpunkt der Annäherung des ersten Substrats 2 in Richtung des zweiten Substrats 5 der Abstand an verschiedenen Stellen gemessen werden, so dass durch entsprechende Steuerung der Antriebsmittel eine entsprechende Rotation der ersten Aufnahmeeinrichtung 1 und damit des ersten Substrats 2 beziehungsweise ein Kippen der ersten Aufnahmeeinrichtung 1 bewirkt wird.

Die Sensoren 8 arbeiten insbesondere mit Weißlichtspektroskopie und entsprechend ist das zweite Substrat 5 zumindest im Bereich der Sensorkammern 7 transparent für Licht- und/oder UV-Strahlung. Soweit auch das erste Substrat 2 transparent für Licht- und/oder UV-Strahlung ist, kann durch die Sensoren auch der Abstand des Sensors 8 zu einer Auflagefläche 2a des ersten Substrats auf der Aufnahmeseite 1a gemessen werden. Ebenso ist der Abstand einer Auflagefläche 5a des zweiten Substrats 5 auf der Aufnahmeseite 6a messbar, so dass auch die Dicken der Substrate 2, 5 in den Bereichen messbar sind, in welchen die Strahlengänge der Sensoren 8 verlaufen.

Somit können sowohl ein Fehler in der Bewegung der ersten Aufnahmeeinrichtung 1 in Translationsrichtung T als auch eine fehlerhafte anfängliche Ausrichtung sowie Fehler der Dicken des ersten Substrats 2 oder des zweiten Substrats 5 oder Unebenheiten der Aufnahmeflächen 1a, 6a kompensiert werden, während die Annäherung der ersten Oberfläche 2o an die zweite Oberfläche 5o erfolgt.

Zur weiteren Optimierung der spektroskopischen Messung und Erhöhung der Genauigkeit der Messung ist in einer vorteilhaften Ausführungsform der Erfindung vorgesehen, dass die Prägestruktur 3 und das Prägematerial 4 außerhalb des Strahlengangs der Sensoren 8 angeordnet sind. Somit werden Fehlbewertungen der Spektroskopie vermieden und die Genauigkeit der Ermittlung der Abstände durch die Spektroskopie der Sensoren erhöht.

Durch die erfindungsgemäße Ausgestaltung wird damit das Problem der inhomogenen Prägung eines Mikrolinsenfeldes auf Grund von Keilfehlern zwischen den Prägeflächen beziehungsweise Flächen des ersten Substrats 2 und des zweiten Substrats 5 durch die Verwendung eines optischen Wegesystems bestehend aus mehreren Sender-Empfängermodulen, nämlich den Sensoren 8, gelöst, mit welchen der Abstand des als Prägestempel ausgebildeten ersten Substrats 2 zur Oberfläche 5o des als Trägerwafer ausgebildeten zweiten Substrats 5 aktiv gemessen und gleichzeitig während der Annäherung der Prägestruktur 3 durch Kippen oder rotieren der ersten Aufnahmeeinrichtung 1 so nachgestellt wird, dass die Oberfläche 2o zur Oberfläche 5o parallel ausgerichtet ist, und zwar im Idealfall ohne Keilfehler.

Die Vorteile der Erfindung liegen in einer höheren Ausbeute an Mikrolinsen innerhalb des Mikrolinsenfeldes, da eine gleich bleibende Qualität der Linsen entlang des gesamten Trägerwafers gewährleistet werden kann. Durch die höhere Ausbeute an Linsen mit vernachlässigbarem Fehler in der optischen Achse der Linsen ergeben sich eindeutig wirtschaftliche und technische Vorteile, insbesondere bei Kopplung mehrerer Mikrolinsen übereinander. Neben den wirtschaftlichen Vorteilen des sinkenden Stückpreises durch höhere Ausbeute ergibt sich außerdem der technische Vorteil einer höheren Bildqualität.

### Bezugszeichenliste

- 1: erste Aufnahmeeinrichtung
- 1a: Aufnahmefläche
- 2: erstes Substrat
- 2a: Auflagefläche
- 2o: Oberfläche
- 3: Prägestruktur
- 4: Prägematerial
- 5: zweites Substrat
- 5a: Auflagefläche
- 5o: Oberfläche
- 6: zweite Aufnahmeeinrichtung
- 6a: Aufnahmefläche
- 7: Sensorkammer
- 8: Sensor
- T: Translationsrichtung

## Patentansprüche

1. Vorrichtung zur gegenüberliegenden Ausrichtung einer ersten Oberfläche (2o) eines ersten Substrats (2) mit einer zweiten Oberfläche (5o) eines zweiten Substrats (5) mit Abstand zwischen der ersten und der zweiten Oberfläche (2o, 5o) mit folgenden Merkmalen:
- eine erste Aufnahmeeinrichtung (1) zur Aufnahme des ersten Substrats (2) auf einer ersten Aufnahmefläche (1a),
- eine zweite Aufnahmeeinrichtung (6) zur Aufnahme des zweiten Substrats (5) auf einer zweiten Aufnahmefläche (6a),
- Annäherungsmittel zur Annäherung der ersten Oberfläche (2o) zur zweiten Oberfläche (5o) in einer Translationsrichtung (T) bis in eine Endposition,
- Mittel zur Verringerung eines Keilfehlers zwischen der ersten und zweiten Oberfläche (2o, 5o) während der Annäherung der ersten Oberfläche (2o) zur zweiten Oberfläche (5o) mit Messmitteln zur in-situ Messung der Winkellage zwischen dem ersten Substrat und dem zweiten Substrat während der Annäherung der ersten Oberfläche (2o) zur zweiten Oberfläche (5o), **dadurch gekennzeichnet, dass** die Messmittel Spektroskopisch arbeitende Messmittel sind und mehrere Sensoren (8) zur Messung der Abstände der ersten Oberfläche (2o) und der zweiten Oberfläche (5o) zu dem jeweiligen Sensor (8) in Translationsrichtung (T) aufweisen.

2. Vorrichtung nach Anspruch 1, **dadurch gekennzeichnet, dass** die Mittel zur Verringerung des Keilfehlers kontinuierlich, insbesondere ununterbrochen, während der Annäherung, insbesondere bis zum Erreichen der Endposition, einsetzbar sind.

3. Vorrichtung nach einem der vorhergehenden Ansprüche, **dadurch gekennzeichnet, dass** auf der ersten Oberfläche (2o) und/oder der zweiten Oberfläche (5o) Prägestrukturen (3) zum Prägen eines Prägematerials (4) zwischen der ersten und der zweiten Oberfläche (2o, 5o) vorgesehen sind.

4. Vorrichtung nach einem der vorhergehenden Ansprüche, **dadurch gekennzeichnet, dass** die Mittel zur Annäherung eine Translationsbewegung der ersten und zweiten Aufnahmeeinrichtung (1, 6) in der Translationsrichtung (T) quer zu den Aufnahmeflächen (1a, 6a) bewirkend ausgebildet sind.

5. Vorrichtung nach einem der vorhergehenden Ansprüche, **dadurch gekennzeichnet, dass** die Messmittel mindestens drei, insbesondere in der ersten und/oder zweiten Aufnahmeeinrichtung (1, 6) jeweils unterhalb der ersten und/oder zweiten Aufnahmefläche (1a, 6a) verbaute, Sensoren (8) aufweisen.

6. Vorrichtung nach Anspruch 1, **dadurch gekennzeichnet, dass** die Sensoren (8) zur Messung der Abstände einer der ersten Oberfläche (2o) abgewandten ersten Auflagefläche (2a) des ersten Substrats (2) und einer der zweiten Oberfläche (5o) abgewandten zweiten Auflagefläche (5a) des zweiten Substrats (5) vorgesehen sind.

7. Vorrichtung nach einem der vorhergehenden Ansprüche, **dadurch gekennzeichnet, dass** die Mittel zur Verringerung des Keilfehlers Antriebsmittel zur Änderung der Winkellage des ersten Substrats (2) zum zweiten Substrat (5), insbesondere ersten Oberfläche (2o) zur zweiten Oberfläche (5o), umfassen, wobei die Antriebsmittel an der ersten und/oder der zweiten Aufnahmeeinrichtung (1, 6) angeordnet sind.

8. Vorrichtung nach einem der vorhergehenden Ansprüche, **dadurch gekennzeichnet, dass** die Mittel zur Verringerung des Keilfehlers eine aktive Steuerungseinrichtung zur Steuerung der Verringerung des Keilfehlers, insbesondere zur Erfassung der Messwerte der Messmittel und zur korrespondierenden Ansteuerung der Antriebsmittel, umfassen.

9. Verfahren zur gegenüberliegenden Ausrichtung einer ersten Oberfläche (20) eines ersten Substrats (2) mit einer zweiten Oberfläche (50) eines zweiten Substrats (5) mit Abstand zwischen der ersten und der zweiten Oberfläche, wobei ein Keilfehler zwischen der ersten und der zweiten Oberfläche während der Annäherung der ersten Oberfläche zur zweiten Oberfläche mittels Messmitteln zur in-situ Messung der Winkellage zwischen dem ersten Substrat und dem zweiten Substrat während der Annäherung der Substrate verringert wird, **dadurch gekennzeichnet, dass** die Messmittel Spektroskopisch arbeitende Messmittel sind und mehrere Sensoren (8) zur Messung der Abstände der ersten Oberfläche (20) und der zweiten Oberfläche (50) zu dem jeweiligen Sensor (8) in Translationsrichtung (T) aufweisen.

## Claims

1. Device for opposite alignment of a first surface (2o) of a first substrate (2) with a second surface (5o) of a second substrate (5) with a gap between the first and the second surfaces (2o, 5o) with the following features:
- A first retaining system (1) for retaining the first substrate (2) on a first retaining surface (1a),
- A second retaining system (6) for retaining the second substrate (5) on a second retaining surface (6a),
- Approach means for causing the first surface (2o) to approach the second surface (5o) in one direction of translation (T) as far as into one end position,
- means for reducing a wedge error between the first and second surfaces (2o, 5o) during the approach of the first surface (2o) to the second surface (5o) including measurement means for in-situ measurement the angular position between the first substrate and the second substrate during the approach of the first surface (2o) to the second surface (5o),
**characterized in that** the measurement means are spectroscopically working measurement means and have several sensors (8) for measuring the gaps of the first surface (2o) and of the second surface (5o) to the respective sensor (8) in the direction of translation (T).

2. Device according to Claim 1, wherein the means to reduce the wedge error can be used continuously, especially uninterruptedly, during the approach, especially until reaching the end position.

3. Device according to one of the preceding claims, wherein on the first surface (2o) and/or the second surface (5o), there are embossing structures (3) for embossing of an embossing material (4) between the first and second surfaces (2o, 5o).

4. Device according to one of the preceding claims, wherein the means for the approach are made to cause a translational movement of the first and second retaining systems (1, 6) in the direction of translation (T) transversely to the retaining surfaces (1a, 6a).

5. Device according to one of the preceding claims, wherein the measurement means have at least three sensors (8) installed in particular in the first and/or second retaining system (1, 6), each underneath the first and/or second retaining surface (1a, 6a).

6. Device according to Claim 1, wherein the sensors (8) are designed for measuring the gaps of a first support surface (2a) of the first substrate (2) facing away from the first surface (2o) and a second support surface (5a) of the second substrate (5) facing away from the second surface (5o).

7. Device according to one of the preceding claims, wherein the means for reducing the wedge error comprise driving means for changing the angular position of the first substrate (2) to the second substrate (5), especially of the first surface (2o) to the second surface (5o), the driving means being located on the first and/or second retaining system (1, 6).

8. Device according to one of the preceding claims, wherein the means for reducing the wedge error comprise an active control system for controlling the reduction of the wedge error, especially for detecting the measurement values of the measurement means and for corresponding triggering of the driving means.

9. Method for opposite alignment of a first surface (2o) of a first substrate (2) with a second surface (5o) of a second substrate (5) with a gap between the first and the second surfaces, wherein a wedge error between the first and the second surfaces is reduced during the approach of the first surface to the second surface by measurement means for an in situ measurement of the angular position between the first substrate and the second substrate during the approach of the substrates (2, 5), **characterized in that** the measurement means are spectroscopically working measurement means and have several sensors (8) for measuring the gaps of the first surface (2o) and of the second surface (5o) to the respective sensor (8) in the direction of translation (T).

## Revendications

1. Dispositif pour l'alignement opposé d'une première surface (20) d'un premier substrat (2) avec une seconde surface (50) d'un second substrat (5) avec une distance entre les première et seconde surfaces (20, 50), ayant les caractéristiques suivantes :
- un premier dispositif de réception (1) pour recevoir le premier substrat (2) sur une première surface de réception (1a),
- un second dispositif de réception (6) pour recevoir le second substrat (5) sur une seconde surface de réception (6a),
- des moyens d'approche pour rapprocher la première surface (20) vers la seconde surface (50) dans un sens de translation (T) jusqu'à une position finale,
- des moyens de réduction d'une erreur de coin entre les première et seconde surfaces (20, 50) pendant le rapprochement de la première surface (20) vers la seconde surface (50) comprenant des moyens de mesure pour la mesure in-situ de la position angulaire entre le premier substrat et le second substrat pendant le rapprochement de la première surface (20) vers la seconde surface (50), **caractérisé en ce que** les moyens de mesure sont des moyens de mesure fonctionnant selon un principe spectroscopique et présentent une pluralité de capteurs (8) pour mesurer les distances de la première surface (20) et de la seconde surface (50) par rapport au capteur respectif (8) dans le sens de translation (T).

2. Dispositif selon la revendication 1, **caractérisé en ce que** les moyens de réduction de l'erreur de coin peuvent être utilisés de façon continue, en particulier ininterrompue pendant le rapprochement, en particulier jusqu'à ce que la position finale soit atteinte.

3. Dispositif selon l'une des revendications précédentes, **caractérisé en ce que** des structures d'estampage (3) pour estamper un matériau à estamper (4) entre les première et seconde surfaces (2o, 50) sont prévues sur la première surface (20) et/ou la seconde surface (50).

4. Dispositif selon l'une des revendications précédentes, **caractérisé en ce que** les moyens de rapprochement sont conçus en effectuant un mouvement de translation des premier et second dispositifs de réception (1, 6) dans le sens de translation (T) transversalement aux surfaces de réception (1a, 6a).

5. Dispositif selon l'une des revendications précédentes, **caractérisé en ce que** les moyens de mesure présentent au moins trois capteurs (8), montés en particulier dans les premier et/ou second dispositifs de réception (1, 6), respectivement en-dessous des première et/ou seconde surfaces de réception (1a, 6a).

6. Dispositif selon la revendication 1, **caractérisé en ce que** les capteurs (8) sont prévus pour mesurer les distances d'une première surface de pose (2a) du premier substrat (2) détournée de la première surface (20) et d'une seconde surface de pose (5a) du second substrat (5) détournée de la seconde surface (50).

7. Dispositif selon l'une des revendications précédentes, **caractérisé en ce que** les moyens de réduction de l'erreur de coin comprennent des moyens d'entraînement pour modifier la position angulaire du premier substrat (2) par rapport au second substrat (5), en particulier de la première surface (20) par rapport à la seconde surface (50), sachant que les moyens d'entraînement sont disposés sur les premier et/ou second dispositifs de réception (1, 6).

8. Dispositif selon l'une des revendications précédentes, **caractérisé en ce que** les moyens de réduction de l'erreur de coin comprennent un dispositif de commande actif pour commander la réduction de l'erreur de coin, en particulier pour détecter les valeurs de mesure des moyens de mesure et pour la commande correspondante des moyens d'entraînement.

9. Procédé pour l'alignement opposé d'une première surface (20) d'un premier substrat (2) avec une seconde surface (50) d'un second substrat (5) avec une distance entre les première et seconde surfaces (20, 50) sachant qu'une erreur de coin entre les première et seconde surfaces pendant le rapprochement de la première surface vers la seconde surface est réduite via des moyens de mesure pour la mesure in-situ de la position angulaire entre le premier substrat et le second substrat pendant le rapprochement des substrats, **caractérisé en ce que** les moyens de mesure sont des moyens de mesure fonctionnant selon un principe spectroscopique et présentent une pluralité de capteurs (8) pour mesurer les distances de la première surface (20) et de la seconde surface (50) par rapport au capteur respectif (8) dans le sens de translation (T).
